# EUROPEAN PATENT SPECIFICATION

(11) **EP 3 121 609 B1**
(45) Date of publication and mention of the grant of the patent: **01.09.2021**
(21) Application number: 15765183.7
(22) Date of filing: 20.03.2015
(51) Int. Cl.: G01R 31/52, G01R 15/18, H02H 3/33

(54) **DIRECT-CURRENT RESIDUAL-CURRENT DETECTING DEVICE**
VORRICHTUNG ZUR ERKENNUNG VON GLEICHSTROM-RESTSTROM
DISPOSITIF DE DÉTECTION DE COURANT CONTINU-COURANT RÉSIDUEL

(30) Priority: 21.03.2014 CN 201410106918
(43) Date of publication of application: 25.01.2017
(73) Proprietor: Seari Electric Technology Co., Ltd., Shanghai 200063 (CN); Zhejiang Chint Electrics Co., Ltd., Yueqing, Zhejiang 325603 (CN)
(72) Inventor: XU, Lei, Shanghai 200063 (CN); CHEN, Yongliang, Shanghai 200063 (CN); YANG, Shijiang, Shanghai 200063 (CN)
(74) Representative: Osha Liang
(86) International application number: PCT/CN2015/074668
(87) International publication number: WO 2015/139654

(56) References cited:
- CN-A- 1 712 973
- CN-A- 101 208 845
- CN-A- 101 949 965
- CN-A- 101 949 987
- CN-Y- 2 482 694
- US-A- 4 298 838
- US-A- 5 223 789
- US-A1- 2011 006 779
- FILANOVSKY I M ET AL: "SENSING AND MEASUREMENT OF DC CURRENT USING A TRANSFORMER AND RL-MULTIVIBRATOR", IEEE TRANSACTIONS ON CIRCUITS AND SYSTEMS, IEEE INC. NEW YORK, US, vol. 38, no. 11, 1 November 1991 (1991-11-01), pages 1366-1370, XP000270295, DOI: 10.1109/31.99166

## Description

### BACKGROUND OF THE INVENTION

### 1. Field of the Invention

The present invention relates to residual current detection field, more particularly, relates to a DC residual current detection apparatus supplied by a unipolar power supply.

### 2. The Related Art

Traditional residual current detection methods include AC type residual current detection method which can detect power frequency sinusoidal residual current only, A type residual current detection method which can detect power frequency sinusoidal residual current and pulsant DC residual current, and B type residual current detection method which can detect smooth DC residual current. The AC type residual current detection method utilizes an alternating magnetic field generated by an alternating residual current existing in a primary winding of a residual current transformer. The alternating magnetic field will induct an alternating induction current in a secondary winding of the residual current transformer, so that the residual current detection may be realized. The pulsant DC residual current also has a variation in current amount, though the range of variation is not so large as the power frequency sinusoidal residual current. The pulsant DC residual current can cause an effective variation in magnetic flux, which may generate an induction current in a secondary winding of a residual current transformer,

With the development of power electronic technology, frequency invertors, medical equipment and UPS are widely used. When these devices have malfunctions, residual currents generated by these devices are not limited to power frequency sinusoidal residual current or pulsant DC residual current, smooth DC residual current also appears. Under such complex waveforms, a magnetic field of a magnetic core for sinusoidal alternating residual current or pulsant DC residual current will bias or even approach saturation, which will cause a reduction in magnetic field intensity and induced potential of the magnetic core. Then detection sensitivity of a secondary winding of the residual current transformer decreases.

US 4,276,510 discloses an apparatus for sensing current transformer primary current. A secondary winding of a current transformer is driven by a high frequency AC source, an inductance sensor alternately senses the secondary winding inductances. Any difference in these inductances is a function of low frequency primary current and is utilized to develop a current flowing through a tertiary core winding. This tertiary winding current thus becomes a precise measure of the primary current. US 4,276,510 varies an inductance (magnetic permeability), saturation in advance shall be avoided, and unsaturation under a fault current shall also be avoided (unless the fault current is too small). A reversion shall occur before complete saturation, a reversion period is determined by resistance values of resistors R1, R2, R3 and turn-on voltages of transistors. US 4,276,510 uses a tertiary core winding and complex analog circuits, which will greatly increase difficulty and cost of implementation, and will influence the accuracy of detection.

Most of other existing DC residual current detection methods also apply a high frequency AC source to a secondary winding of a current transformer to generate an alternating excitation current having equal positive and negative peak values through saturation of a magnetic core. To obtain a positive/negative alternating excitation current, a bipolar power supply is used in an excitation circuit according to prior art. A bipolar power supply will increase power consumption, and need extra elements such as a transformer to construct a relatively complex circuit, which will increase the cost of the circuit. Further, a complex excitation circuit is a challenge for small protection devices which require small dimension designs and electromagnetic compatibility considerations.

US 2011/006779 A1 is directed to a flux-gate leakage current sensor comprising an annular core, a coil wound, a driving circuit, a comparator circuit, and a determination circuit. US4298838A is directed to a transformer device comprising a saturable magnetic core being controlled in a feedback mode through switch means such as transistor switch means. The document Filanovsky et al., Sensing and measurement of DC current using a transformer and RL-multivibrator, IEEE Transactions on circuits and systems, IEEE INC. NEW YORK, US, vol. 38, no. 11, pages 1366-1370, 1991, describes a circuit for sensing and measurement of dc current using a transformer and a R/L-multivibrator.

### SUMMARY

The present invention provides a direct current (DC) residual current detection apparatus, which is driven by an unipolar power supply. The apparatus is provided with full current detection ability and simple structure.

According to an embodiment of the present invention, a direct current (DC) residual current detection apparatus is disclosed. The apparatus is driven by an unipolar power supply and comprises a power conversion self-balancing circuit, a square wave pulse voltage driving circuit, a residual current transformer and a comparator.

An input end of the power conversion self-balancing circuit is connected to the unipolar power supply, the power conversion self-balancing circuit converts the unipolar power supply to a bipolar power supply and outputs the bipolar power supply, the power conversion self-balancing circuit supplies the square wave pulse voltage driving circuit, the residual current transformer and the comparator.

The residual current transformer is formed with an RL multivibrator, the square wave pulse voltage driving circuit circularly applies positive or negative voltages to a secondary winding of the residual current transformer, the residual current transformer outputs a corresponding sampling voltage.

The comparator obtains the sampling voltage outputted by the residual current transformer, compares the sampling voltage with a threshold voltage of the comparator and generates a square wave signal alternating between positive and negative, the square wave signal is fed back as the output of the comparator to the square wave pulse voltage driving circuit as a driving signal.

The output of the comparator is further used as the output of the apparatus for representing a polarity and scale of the DC residual current.

According to an embodiment, the residual current transformer comprises a magnetic core, a multi turn inductance and a sampling resistor. The magnetic core is amorphous alloy material, a distribution line for DC residual current detection passes through the magnetic core, the distribution line and the magnetic core form a primary winding of the residual current transformer. The multi turn inductance winds on the magnetic core to form the secondary winding of the residual current transformer. The multi turn inductance and the sampling resistor form the RL multivibrator. The sampling voltage is obtained from the ends of the sampling resistor.

According in an embodiment, the comparator is a retardation comparator, the comparator comprises a first operational amplifier, an anti-phase input end of the first operational amplifier is connected to the sampling resistor via a current limiting resistor to obtain the sampling voltage, an in-phase input end of the first operational amplifier is connected to a threshold voltage generation circuit to obtain the threshold voltage, an output end of the first operational amplifier is connected to the current limiting resistor and a filter capacitor, the current limiting resistor and the filter capacitor perform current limiting, interference suppression and filtering for the output of the first operational amplifier.

According to an embodiment, the square wave pulse voltage driving circuit is a half bridge voltage driving circuit composed of one NPN transistor and one PNP transistor, the bases of the two transistors are connected to each other, the square wave signal alternating between positive and negative, which is outputted by the comparator conducts the NPN transistor and the PNP transistor alternatively, the emitters of the two transistors are connected and output a square wave pulse voltage to the secondary winding of the residual current transformer, the collector of the NPN transistor is connected to the positive power supply, the collector of the PNP transistor is connected to the negative power supply.

According to an embodiment, the maximum collector current of the NPN transistor and the PNP transistor is associated with the number of turns of the multi turn inductance, the characteristic of the magnetic core, and the resistance of the sampling resistor.

According to an embodiment, the power conversion self-balancing circuit comprises a second operational amplifier, an in-phase input end of the second operational amplifier is connected to a resistor series voltage divider, two ends of the resistor series voltage divider are connected to the positive end and the negative end of the unipolar power supply respectively, an anti-phase input end of the second operational amplifier is connected to ground via a low resistance resistor, an output end of the second operational amplifier is connected to the anti-phase input end of the second operational amplifier to construct a voltage follower and form two power supplies which are symmetric: one power supply is formed by the positive polar of the unipolar power supply and ground, the other power supply is formed by ground and the negative polar of the unipolar power supply.

According to an embodiment, the first operational amplifier and the second operational amplifier are same type, which is provided with a slew rate ≥ 13V/us, a gain bandwidth ≥ 4MHz and a maximum current output ≥ + 35mA.

According to an embodiment, the RL multivibrator of the residual current transformer forms RL multivabration based on the characteristic of non linear magnetization curve of ferromagnetic material. The secondary winding of the residual current transformer, the square wave pulse voltage driving circuit and the comparator form cyclic self excited oscillation, a square wave voltage is applied on two ends of the secondary winding of the residual current transformer and circularly alternates the direction of the current flowing through the secondary winding of the residual current transformer, so that the magnetic core of the residual current transformer alternates between positive saturation and negative saturation.

According to an embodiment, when no DC residual current exists in the primary winding of the residual current transformer, the positive saturation excitation current and the negative saturation excitation current of the magnetic core of the residual current transformer is symmetric. When DC residual current exists in the primary winding of the residual current transformer, the positive saturation excitation current and the negative saturation excitation current of the magnetic core of the residual current transformer is asymmetric.

According to an embodiment, an average value of the voltage outputted by the comparator represents the polarity and scale of the DC residual current in the secondary winding of the residual current transformer; the average value of the voltage is associated with the duty ratio of the square wave signal.

The DC residual detection apparatus of the present invention is able to detect residual current in a full current range including smooth DC residual current, power frequency sinusoidal residual current, pulsant DC residual current or residual currents superposed thereon. The DC residual detection apparatus is constructed by a few low cost elements and is supplied by an unipolar power supply. The unipolar power supply is converted into a bipolar power supply by a power conversion self-balancing circuit. The DC residual detection apparatus has high reliability, simple structure and is easy to implement.

### BRIEF DESCRIPTION OF THE DRAWINGS

The above and other features, natures, and advantages of the invention will be apparent by the following description of the embodiments incorporating the drawings, wherein,
FIG. 1 illustrates a schematic diagram of a circuit structure of a DC residual detection apparatus according to an embodiment of the present invention.
FIG. 2 illustrates a schematic diagram of a circuit structure of a residual current transformer of the DC residual detection apparatus according to an embodiment of the present invention.
FIG. 3 illustrates a schematic diagram of a circuit structure of a comparator of the DC residual detection apparatus according to an embodiment of the present invention.
FIG. 4 illustrates a schematic diagram of a circuit structure of a square wave pulse voltage driving circuit of the DC residual detection apparatus according to an embodiment of the present invention.
FIG. 5 illustrates a schematic diagram of a circuit structure of a power conversion self-balancing circuit of the DC residual detection apparatus according to an embodiment of the present invention.
FIG. 6 illustrates a magnetization curve of a magnetic core of a residual current transformer of the DC residual detection apparatus according to an embodiment of the present invention.
FIG. 7 illustrates waveforms of the excitation voltage on the ends of the secondary winding of the residual current transformer, the excitation current in the secondary winding and the voltage on the ends of the sampling resistor when no DC residual current exists.
FIG. 8 illustrates waveforms of the excitation voltage on the ends of the secondary winding of the residual current transformer, the excitation current in the secondary winding and the voltage on the ends of the sampling resistor when DC residual current exists.

### DETAILED DESCRIPTION OF EMBODIMENTS

The DC residual detection apparatus according to the present invention is an RL multivibration based DC residual detection apparatus supplied by a unipolar power supply. Depending on the characteristic of non linear magnetization curve of ferromagnetic material, the DC residual detection apparatus utilizes RL multivibration to carry out magnetic modulation for a magnetic core of a residual current transformer, so that a DC residual current that cannot be detected by a traditional residual current transformer may be represented by outputs of particular circuits.

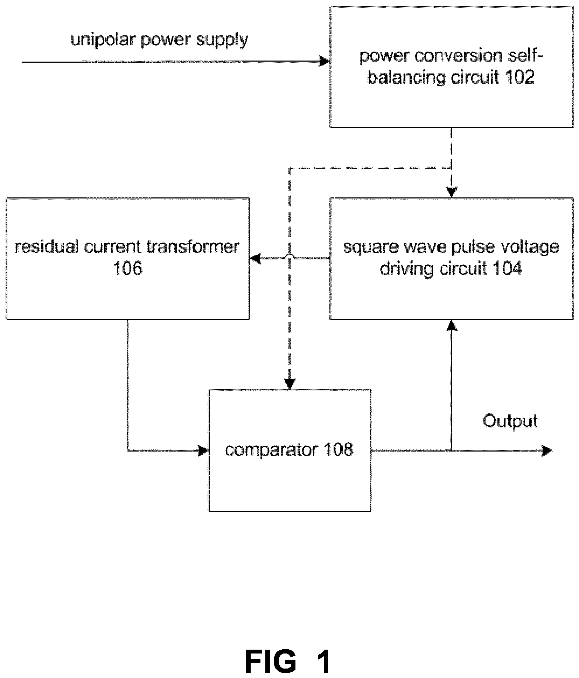

According to FIG. 1, FIG. 1 illustrates a schematic diagram of a circuit structure of a DC residual detection apparatus according to an embodiment of the present invention. The DC residual detection apparatus is driven by a unipolar power supply. The DC residual detection apparatus comprises: a power conversion self-balancing circuit 102, a square wave pulse voltage driving circuit 104, a residual current transformer 106 and a comparator 108.

An input end of the power conversion self-balancing circuit 102 is connected to the unipolar power supply, the power conversion self-balancing circuit 102 converts the unipolar power supply to a bipolar power supply and outputs the bipolar power supply. The power conversion self-balancing circuit 102 supplies power to the square wave pulse voltage driving circuit 104, the residual current transformer 106 and the comparator108.

The residual current transformer 106 is formed with an RL multivibrator. The square wave pulse voltage driving circuit 104 circularly applies positive or negative voltages to a secondary winding of the residual current transformer 106. The residual current transformer 106 outputs a corresponding sampling voltage.

The comparator 108 obtains the sampling voltage outputted by the residual current transformer 106, compares the sampling voltage with a threshold voltage of the comparator 108 and generates a square wave signal alternating between positive and negative. The square wave signal is fed back as the output of the comparator 108 to the square wave pulse voltage driving circuit 104 as a driving signal.

The output of the comparator 108 is further used as the output of the apparatus for representing a polarity and scale of the DC residual current.

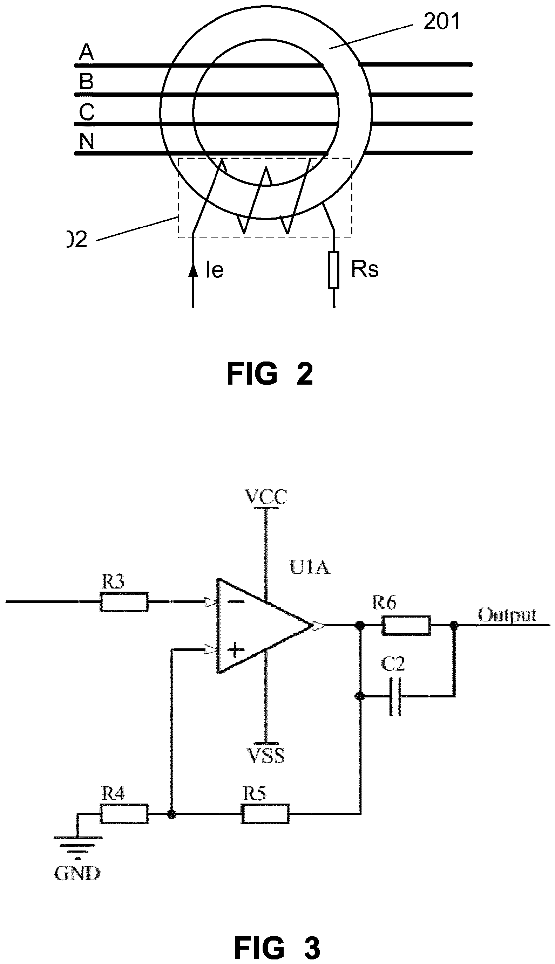

Referring to FIG. 2, FIG. 2 illustrates a schematic diagram of a circuit structure of a residual current transformer of the DC residual detection apparatus according to an embodiment of the present invention. The residual current transformer comprises a magnetic core 201, a multi turn inductance 202 and a sampling resistor Rs. The magnetic core 201 is made of amorphous alloy material. Distribution lines A, B, C, N, which are planned for DC residual current detection, pass through the magnetic core 201. The distribution lines A, B, C, N and the magnetic core 201 form a primary winding of the residual current transformer. The magnetic core 201 is made of an amorphous alloy material with good high frequency characteristic. In normal working condition, the amorphous alloy material magnetic core 201 will reach a saturation status under high frequency with a very small excitation current le. Compared with Permalloy, amorphous alloy has higher saturation magnetic induction intensity and initial permeability, and lower residual magnetic induction intensity and coercive force. Amorphous alloy further has a better rectangularity. Therefore, when working under high frequency, the amorphous alloy material magnetic core 201 may reach a saturation status with a very small excitation current le. Such characteristics bring an advantage of power consumption reduction and circuit design simplification. The four conductive bodies A, B, C, N shown in FIG. 2 are distribution lines where residual current may exists, the distribution lines A, B, C, N pass through the magnetic core 201 of the residual current transformer to form the primary winding of the residual current transformer. The multi turn inductance 202 winds on the magnetic core 201 to form the secondary winding of the residual current transformer. The multi turn inductance 202 and the sampling resistor Rs form the RL multivibrator. The sampling voltage is obtained from the ends of the sampling resistor Rs. The excitation voltage of the residual current transformer is provided by the square wave pulse voltage driving circuit 104.

Referring to FIG. 3, FIG. 3 illustrates a schematic diagram of a circuit structure of a comparator of the DC residual detection apparatus according to an embodiment of the present invention. The comparator 106 is a retardation comparator. The comparator comprises a first operational amplifier U1A. An anti-phase input end of the first operational amplifier U1A is connected to the sampling resistor via a current limiting resistor so as to obtain the sampling voltage. An in-phase input end of the first operational amplifier U1A is connected to a threshold voltage generation circuit so as to obtain the threshold voltage. An output end of the first operational amplifier U1A is connected to the current limiting resistor and a filter capacitor. The current limiting resistor and the filter capacitor perform current limiting, interference suppression and filtering for the output of the first operational amplifier. The first operational amplifier U1A is further connected to a positive power supply Vcc and a negative power supply Vss. As shown in FIG. 3, the first operational amplifier U1A may be realized by TL082, which is a high performance operational amplifier with high gain, low noise and large output current. Basic parameters of the first operational amplifier U1A are as follows: a slew rate ≥ 13V/us, a gain bandwidth ≥ 4MHz and a maximum current output ≥ ± 35mA. A resistor R4 and a resistor R5 form the threshold voltage generation circuit which provides the threshold voltage Ur. The threshold voltage generation circuit is connected to the in-phase input end of the first operational amplifier U1A and the potential of this point is used as the in-phase input voltage of the first operational amplifier U1A. Resister R3 and resistor R6 are current limiting resistors. One end of the resistor R3 is connected to the anti-phase input end of the first operational amplifier U1A, the other end of the resistor R3 is connected to the sampling resistor Rs. The resistor R3 limits the input current of the first operational amplifier U1A. The resistor R6 is connected to the output end of the first operational amplifier U1A, the resistor R6 limits the output current of the first operational amplifier U1A. Capacitor C2 performs interference suppression and filtering.

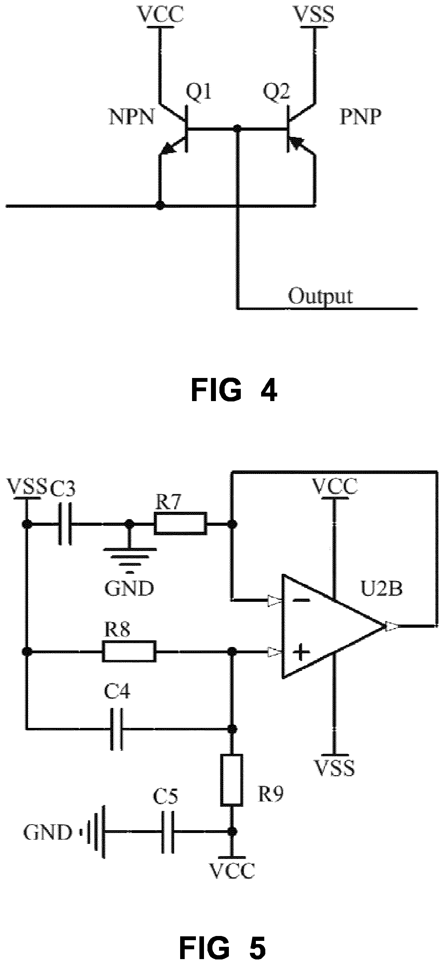

Referring to FIG.4, FIG. 4 illustrates a schematic diagram of a circuit structure of a square wave pulse voltage driving circuit of the DC residual detection apparatus according to an embodiment of the present invention. The square wave pulse voltage driving circuit 104 is a half bridge voltage driving circuit composed of one NPN transistor and one PNP transistor. The bases of the two transistors are connected to each other. The square wave signal alternating between positive and negative, which is outputted by the comparator, conducts the NPN transistor and the PNP transistor alternatively. The emitters of the two transistors are connected and output a square wave pulse voltage to the secondary winding of the residual current transformer. The collector of the NPN transistor is connected to the positive power supply, and the collector of the PNP transistor is connected to the negative power supply. The maximum collector current of the NPN transistor and the PNP transistor is associated with the number of turns of the multi turn inductance, the characteristic of the magnetic core, and the resistance of the sampling resistor. As shown in FIG. 4, the NPN transistor Q1 and the PNP transistor Q2 form the half bridge voltage driving circuit. The bases of the transistors Q1 and Q2 are connected to each other. Different transistors (Q1 or Q2) will be conducted according to the polarity (positive or negative) of the voltage outputted by the comparator 106. The emitters of the transistors Q1 and Q2 are connected and output a square wave pulse voltage to the secondary winding of the residual current transformer. The collector of the NPN transistor Q1 is connected to the positive power supply Vcc, and the collector of the PNP transistor Q2 is connected to the negative power supply Vss. The maximum collector current that may pass through the two transistors is associated with the number of turns of the secondary winding of the residual current transformer (the number of turns of the multi turn inductance), the characteristic of the magnetic core, and the resistance of the sampling resistor. The square wave pulse voltage driving circuit is a half bridge voltage driving circuit, a TTL driving signal of the driving circuit is provided by the output of the comparator. The collectors of the NPN transistor and the PNP transistor are connected to the positive and negative power supplies, respectively. The half bridge voltage driving circuit may conduct different transistors (the NPN transistor or the PNP transistor) according to the polarity (positive or negative) of the voltage outputted by the comparator, therefore positive voltage and negative voltage may be circularly applied to the secondary winding of the residual current transformer. An excitation current with sufficient energy is provided so that the magnetic core may reach a saturation status, the excitation current is not limited by the current output capacity of the operational amplifier of the comparator.

Referring to FIG. 5, FIG. 5 illustrates a schematic diagram of a circuit structure of a power conversion self-balancing circuit of the DC residual detection apparatus according to an embodiment of the present invention. The power conversion self-balancing circuit 102 comprises a second operational amplifier U2B. An in-phase input end of the second operational amplifier U2B is connected to a resistor series voltage divider. Two ends of the resistor series voltage divider are connected to the positive end and the negative end of the unipolar power supply, respectively. An anti-phase input end of the second operational amplifier U2B is connected to ground via a low resistance resistor. An output end of the second operational amplifier U2B is connected to the anti-phase input end of the second operational amplifier U2B to construct a voltage follower and form two power supplies which are symmetric: one power supply is formed by the positive polar (Vcc) of the unipolar power supply and ground (GND), the other power supply is formed by ground (GDN) and the negative polar (Vss) of the unipolar power supply. As shown in FIG. 5, Vcc and Vss are the positive end and the negative end of the externally inputted unipolar power supply. The in-phase input end of the second operational amplifier U2B is connected to a resistor series voltage divider, which is constructed by resistor R8 and resistor R9. Resistor R8 and resistor R9 have the same resistance. Two ends of the resistor series voltage divider are connected to Vcc and Vss, respectively. More particularly, resistor R9 is connected to the positive power supply Vcc, and resistor R8 is connected to the negative power supply Vss. The second operational amplifier U2B itself is constructed as a voltage follower: its output end is connected to the anti-phase input end. One end of a low resistance resistor R7 is connected to the anti-phase input end of the second operational amplifier U2B, the other end of the low resistance resistor R7 acts as a reference ground point (GND) of the entire residual current detection circuit, so as to eliminate the influence caused by dispersion of internal parameters of the operational amplifier. Then two power supplies which are symmetric are formed: one power supply is Vcc and GND, the other power supply is GND and Vss. The two power supplies supply the bipolar power supply, which is required for operation to the comparator 106 and the square wave pulse voltage driving circuit 104. Capacitor C3 and capacitor C5 are decoupling capacitors. Capacitors C3 and C5 are connected to the positive power supply Vcc and the negative power supply Vss, respectively. Capacitor C3 is connected to the negative power supply Vss and capacitor C5 is connected to the positive power supply Vcc. Capacitor C4 and capacitor C8 are connected in parallel for interference suppression and filtering. The second operational amplifier U2B may be realized by the same type operational amplifier as the first operational amplifier U1A, such as TL082, which is a high performance operational amplifier with high gain, low noise and large output current. Basic parameters of the first operational amplifier U1A are as follows: a slew rate ≥ 13V/us, a gain bandwidth ≥ 4MHz and a maximum current output ≥ ± 35mA. Alternatively, a dual operational amplifier may be used to directly combine the first and second operational amplifiers. Generally speaking, the power conversion self-balancing circuit includes a resistor series voltage divider and an operational amplifier constructed as a voltage follower. An in-phase input end of the operational amplifier is connected to the symmetric resistor series voltage divider. The ends of the resistor series voltage divider are connected to the positive end and the negative end of the unipolar power supply, respectively. The operational amplifier is supplied by the unipolar power supply. A potential of the output end of the operational amplifier is strictly equal to a potential of a dividing point of the resistor series voltage divider due to the linear operation characteristic of the operational amplifier. An anti-phase input end of the operational amplifier is connected to a low resistance resistor and acts as a reference ground point of the entire residual current detection circuit, so as to eliminate the influence caused by dispersion of internal parameters of the operational amplifier. Then, the unipolar power supply which supplies the operational amplifier is divided into two symmetric power supplies: one positive power supply and one negative power supply. The output current capacity is associated with the output current capacity of the operational amplifier. If a larger output power is required, a power integrated circuit (such as TDA2030) with a high open loop gain may be used to replace the resistor series voltage divider. Compared with the resistor series voltage divider, the power integrated circuit may avoid asymmetry of a generated bipolar power supply due to backend loads. The asymmetry of the generated bipolar power supply will cause a relatively large bias between the positive voltage and the negative voltage of the bipolar power supply. Therefore, the power integrated circuit may increase precision of the operational amplifier and ensure accuracy of residual current detection.

The DC residual current detection apparatus operates as follows: the RL multivibrator of the residual current transformer forms RL multivabration based on the characteristic of non linear magnetization curve of ferromagnetic material. The secondary winding of the residual current transformer, the square wave pulse voltage driving circuit and the comparator form cyclic self excited oscillation. A square wave voltage is applied on two ends of the secondary winding of the residual current transformer and circularly alternates the direction of the current flowing through the secondary winding of the residual current transformer, so that the magnetic core of the residual current transformer alternates between positive saturation and negative saturation.

When no DC residual current exists in the primary winding of the residual current transformer, the positive saturation excitation current and the negative saturation excitation current of the magnetic core of the residual current transformer is symmetric. When DC residual current exists in the primary winding of the residual current transformer, the positive saturation excitation current and the negative saturation excitation current of the magnetic core of the residual current transformer is asymmetric. An average value of the voltage outputted by the comparator represents the polarity and scale of the DC residual current in the secondary winding of the residual current transformer. The average value of the voltage is associated with the duty ratio of the square wave signal.

More particularly, the cyclic self excited oscillation of the secondary winding of the residual current transformer, the square wave pulse voltage driving circuit and the comparator will generate a square wave voltage with a particular frequency on the ends of the secondary winding of the residual current transformer. The square wave voltage circularly will alternate the direction of the current flowing through the secondary winding of the residual current transformer and make the magnetic core of the residual current transformer alternate between positive saturation and negative saturation. When no DC residual current exists in the primary winding (usually 1 turn) of the residual current transformer, the positive saturation excitation current and the negative saturation excitation current of the magnetic core is symmetric due to the symmetrical characteristic of the magnetization curve of ferromagnetic material. The voltages on both ends of the sampling resistor Rs are symmetric and the average value of the voltage outputted by the comparator is zero. When DC residual current exists in the primary winding (usually 1 turn) of the residual current transformer, the positive saturation excitation current and the negative saturation excitation current of the magnetic core is no longer symmetric under the DC bias magnetic field. The voltages on both ends of the sampling resistor Rs are asymmetric and the average value of the voltage outputted by the comparator is not zero. The average value is associated with the polarity and scale of the DC residual current in the secondary winding of the residual current transformer. The variation in the average value of the voltage outputted by the comparator is caused by the variation in conduction time of the positive voltage or the negative voltage of the square wave pulse voltage driving circuit, and is associated with the variation of duty ratio of the excitation square wave signal.

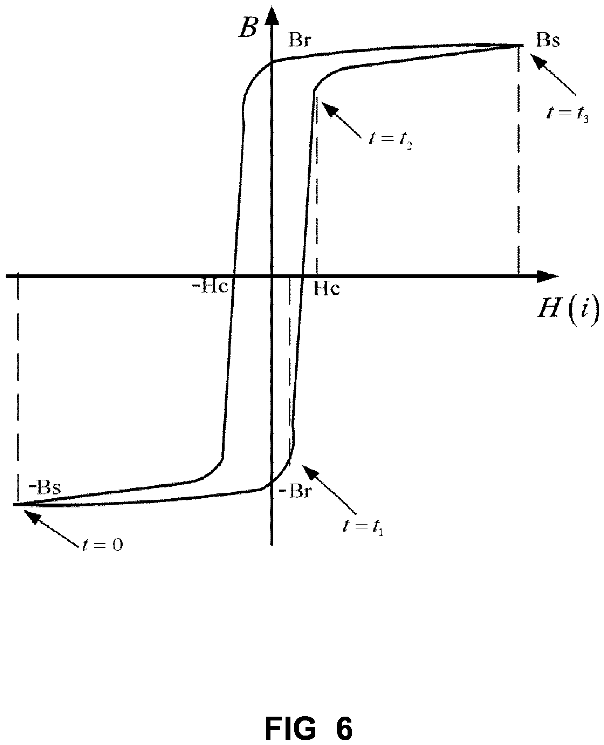

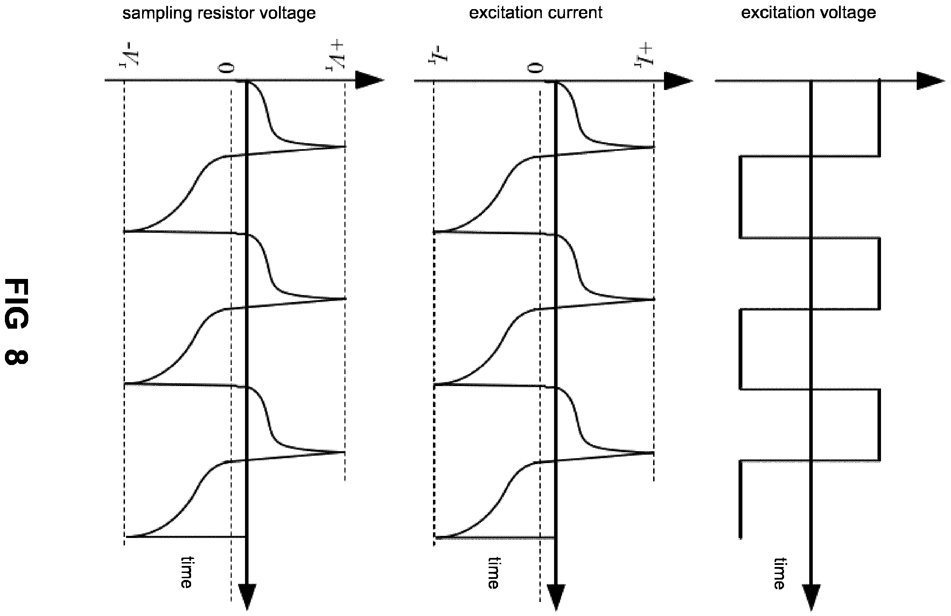

FIG. 6 ∼ FIG. 8 further illustrate the operation principle and operation process of the present invention. FIG. 6 illustrates a magnetization curve of a magnetic core of a residual current transformer of the DC residual detection apparatus according to an embodiment of the present invention. In FIG. 6, Br represents a residual magnetic induction intensity, Hc represents a coercive force, and Bs represents a saturation magnetic induction intensity.

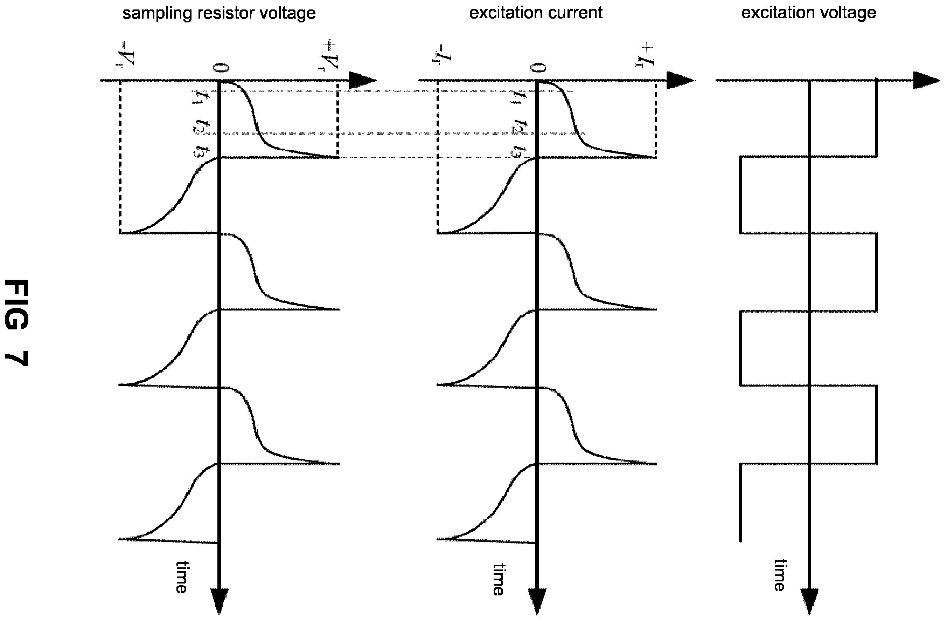

FIG. 7 illustrates waveforms of the excitation voltage on the ends of the secondary winding of the residual current transformer, the excitation current in the secondary winding and the voltage on the ends of the sampling resistor when no DC residual current exists. FIG. 8 illustrates waveforms of the excitation voltage on the ends of the secondary winding of the residual current transformer, the excitation current in the secondary winding and the voltage on the ends of the sampling resistor when DC residual current exists. In FIG. 6, FIG. 7 and FIG. 8, same references t, t1, t2 and t3 are used to represent time points when operation statuses of the magnetic core transit, so that the transitions of the operation process of the present invention may be introduced. In FIG. 7 and FIG. 8, same references T1 and T2 are used to represent the positive induction time and negative induction time of the square wave pulse voltage driving circuit 104.

When the residual current is zero (that is, no residual current exists), waveforms of the excitation voltage on the ends of the secondary winding of the residual current transformer, the excitation current in the secondary winding and the voltage on the ends of the sampling resistor are shown in FIG. 7. Here T1=T2 and the operations in this period are as follows:
(1) Assuming that the excitation voltage is positive half wave at a time t=0. When 0<t<t1, the magnetic core is in a negative magnetic saturation area of the magnetization curve, variation of magnetic induction intensity B is small during this period, a excitation resistance of the secondary winding of the residual current transformer is also small, an excitation current le increases quickly from zero.
(2) When t1<t<t2, the magnetic core enters into a linear area of the magnetization curve, variation of magnetic induction intensity B is large during this period, the excitation resistance becomes larger and the excitation current increases slowly.
(3) When t2<t<t3, the magnetic core enters into a positive magnetic saturation area of the magnetization curve, variation of magnetic induction intensity B becomes smaller during this period, the excitation resistance becomes smaller and the excitation current le increases quickly.
(4) When t=t3, the excitation current le reaches a peak value Ir and the voltage on the sample resistor reaches a threshold voltage Ur of the retardation comparator. An excitation voltage reverses and enters into a negative half period. During the negative half period, variation of the excitation current is similar to that in the positive half period. The positive half period and the negative half period are symmetric.

When the residual current is positive direct current (reference current direction), that is, residual current exists, waveforms of the excitation voltage on the ends of the secondary winding of the residual current transformer, the excitation current in the secondary winding and the voltage on the ends of the sampling resistor Rs are shown in FIG. 8. Here T1<T2, the operations in this period are similar to the operations when no residual current exists. However, when a positive (reference direction) DC residual current exists, the required excitation current le in the positive half period is relatively small under the influence of the positive (reference direction) DC bias magnetic field. While the required excitation current le in the negative half period is relatively large because the positive (reference direction) DC bias need to be overcome. The positive saturation excitation current and the negative saturation excitation current are no longer symmetric.

Similarly, when the residual current is negative direct current (reference current direction), that is, residual current exists, the positive saturation excitation current and the negative saturation excitation current are asymmetric and the average value is not zero. However, when the residual current is negative direct current, contrary to the negative direct current, the required excitation current le in the positive half period is relatively large and the required excitation current le in the negative half period is relatively small.

It should be noted that, FIG. 6, FIG. 7 and FIG. 8 are provided to exemplarily illustrate the operation principle of the present invention. Actual waveforms may change according to the number of turns of the multi turn inductance, the characteristic of the magnetic core, and the resistance of the sampling resistor.

The DC residual detection apparatus of the present invention is able to detect residual current in a full current range including smooth DC residual current, power frequency sinusoidal residual current, pulsant DC residual current or residual currents superposed thereon. The DC residual detection apparatus is constructed by a few low cost elements and is supplied by a unipolar power supply. The unipolar power supply is converted into a bipolar power supply by a power conversion self-balancing circuit. The DC residual detection apparatus has high reliability, simple structure and is easy to implement.

## Claims

1. A direct current (DC) residual current detection apparatus, wherein the apparatus is driven by a unipolar power supply (AA) and comprises a power conversion self-balancing circuit (102), a square wave pulse voltage driving circuit (104), a residual current transformer (106) and a comparator (108);
an input end of the power conversion self-balancing circuit (102) being connected to the unipolar power supply (AA), the power conversion self-balancing circuit (102) being configured to convert the unipolar power supply (AA) to a bipolar power supply and to output the bipolar power supply, the power conversion self-balancing circuit (102) being configured to supply power to the square wave pulse voltage driving circuit (104), the residual current transformer (106) and the comparator (108);
the residual current transformer (106) being formed with a RL multivibrator, the square wave pulse voltage driving circuit (104) being configured to circularly apply positive or negative voltages to a secondary winding of the residual current transformer (106), the residual current transformer (106) configured to output a corresponding sampling voltage;
the comparator (108) being configured to obtain the sampling voltage outputted by the residual current transformer (106), to compare the sampling voltage with a threshold voltage of the comparator (108) and to generate a square wave signal alternating between positive and negative, the square wave signal being fed back as the output of the comparator (108) to the square wave pulse voltage driving circuit (104) as a driving signal;
the output of the comparator being further used as the output (BB) of the apparatus for representing a polarity and scale of the DC residual current.

2. The DC residual current detection apparatus according to claim 1, wherein the residual current transformer (106) comprises a magnetic core, a multi turn inductance and a sampling resistor;
the magnetic core is amorphous alloy material, a distribution line for DC residual current detection passes through the magnetic core, the distribution line and the magnetic core form a primary winding of the residual current transformer;
the multi turn inductance winds on the magnetic core to form the secondary winding of the residual current transformer (106);
the multi turn inductance and the sampling resistor form the RL multivibrator;
the sampling voltage is obtained from the ends of the sampling resistor.

3. The DC residual current detection apparatus according to claim 2, wherein the comparator (108) is a retardation comparator, the comparator (108) comprises a first operational amplifier, an anti-phase input end of the first operational amplifier is connected to the sampling resistor via a current limiting resistor to obtain the sampling voltage, an in-phase input end of the first operational amplifier is connected to a threshold voltage generation circuit to obtain the threshold voltage, an output end of the first operational amplifier is connected to the current limiting resistor and a filter capacitor, the current limiting resistor and the filter capacitor being configured to perform current limiting, interference suppression and filtering for the output of the first operational amplifier.

4. The DC residual current detection apparatus according to claim 3, wherein the square wave pulse voltage driving circuit (104) is a half bridge voltage driving circuit composed of one NPN transistor and one PNP transistor, the bases of the two transistors are connected to each other, the square wave signal alternating between positive and negative, which is outputted by the comparator, being configured to conduct the NPN transistor and the PNP transistor alternatively, the emitters of the two transistors are connected and output a square wave pulse voltage to the secondary winding of the residual current transformer (106), the collector of the NPN transistor is connected to the positive power supply, and the collector of the PNP transistor is connected to the negative power supply.

5. The DC residual current detection apparatus according to claim 4, wherein the maximum collector current of the NPN transistor and the PNP transistor is associated with the number of turns of the multi turn inductance, the characteristic of the magnetic core, and the resistance of the sampling resistor.

6. The DC residual current detection apparatus according to claim 4, wherein the power conversion self-balancing circuit (102) comprises a second operational amplifier, an in-phase input end of the second operational amplifier is connected to a resistor series voltage divider, two ends of the resistor series voltage divider are connected to the positive end and the negative end of the unipolar power supply (AA) respectively, an anti-phase input end of the second operational amplifier is connected to ground via a low resistance resistor, an output end of the second operational amplifier is connected to the anti-phase input end of the second operational amplifier to construct a voltage follower and form two power supplies which are symmetric: one power supply is formed by the positive polar of the unipolar power supply (AA) and ground, the other power supply is formed by ground and the negative polar of the unipolar power supply (AA).

7. The DC residual current detection apparatus according to claim 6, wherein the first operational amplifier and the second operational amplifier are same type, which is provided with a slew rate ≥ 13V/us, a gain bandwidth ≥ 4MHz and a maximum current output ≥ ±35mA.

8. The DC residual current detection apparatus according to claim 6, wherein the RL multivibrator of the residual current transformer forms RL multivibration based on the characteristic of non linear magnetization curve of ferromagnetic material;
the secondary winding of the residual current transformer (106), the square wave pulse voltage driving circuit (104) and the comparator (108) form cyclic self excited oscillation, a square wave voltage is applied on two ends of the secondary winding of the residual current transformer (106) and circularly alternates the direction of the current flowing through the secondary winding of the residual current transformer (106), so that the magnetic core of the residual current transformer (106) alternates between positive saturation and negative saturation.

9. The DC residual current detection apparatus according to claim 8, wherein
when no DC residual current exists in the primary winding of the residual current transformer (106), the positive saturation excitation current and the negative saturation excitation current of the magnetic core of the residual current transformer (106) is symmetric;
when DC residual current exists in the primary winding of the residual current transformer (106), the positive saturation excitation current and the negative saturation excitation current of the magnetic core of the residual current transformer (106) is asymmetric.

10. The DC residual current detection apparatus according to claim 9, wherein
an average value of the voltage outputted by the comparator represents the polarity and scale of the DC residual current in the secondary winding of the residual current transformer (106); the average value of the voltage is associated with the duty ratio of the square wave signal.

## Patentansprüche

1. Gleichstrom- (DC) Reststrom-Erkennungsvorrichtung, wobei die Vorrichtung von einer unipolaren Energieversorgung (AA) angetrieben wird und eine selbstabgleichende Energieumwandlungsschaltung (102), eine Rechteckimpulsspannungs-Treiberschaltung (104), einen Reststromtransformator (106) und einen Komparator (108) aufweist;
wobei ein Eingangsende der selbstabgleichenden Energieumwandlungsschaltung (102) mit der unipolaren Energieversorgung (AA) verbunden ist, wobei die selbstabgleichende Energieumwandlungsschaltung (102) derart ausgeführt ist, dass sie die unipolare Energieversorgung (AA) in eine bipolare Energieversorgung umwandelt und die bipolare Energie ausgibt, wobei die selbstabgleichende Energieumwandlungsschaltung (102) derart ausgeführt ist, dass sie Energie der Rechteckimpulsspannungs-Treiberschaltung (104), dem Reststromtransformator (106) und dem Komparator (108) zuführt;
wobei der Reststromtransformator (106) mit einem RL-Multivibrator ausgebildet ist, wobei die Rechteckimpulsspannungs-Treiberschaltung (104) derart ausgeführt ist, dass sie positive oder negative Spannungen zirkulierend an eine Sekundärwicklung des Reststromtransformators (106) anlegt, der Reststromtransformator (106) derart ausgebildet ist, dass er eine entsprechende Abtastspannung ausgibt;
wobei der Komparator (108) derart ausgeführt ist, dass er die von dem Reststromtransformator (106) ausgegebene Abtastspannung erhält, um die Abtastspannung mit einer Schwellspannung des Komparators (108) zu vergleichen und ein Rechtecksignal zu erzeugen, das zwischen positiv und negativ alterniert, wobei das Rechtecksignal als Ausgangssignal des Komparators (108) als Treibersignal zu der Rechteckimpulsspannungs-Treiberschaltung (104) zurückgeführt wird;
wobei das Ausgangssignal des Komparators ferner als Ausgangssignal (BB) der Vorrichtung zum Darstellen einer Polarität und Skalierung des DC-Reststroms verwendet wird.

2. DC-Reststromerkennungsvorrichtung nach Anspruch 1, wobei der Reststromtransformator (106) einen Magnetkern, eine Mehrfachwindungsinduktivität und ein Abtastwiderstandselement aufweist;
der Magnetkern ein amorphes Legierungsmaterial ist, eine Verteilungsleitung für die DC-Reststromerkennung den Magnetkern durchläuft, die Verteilungsleitung und der Magnetkern eine Primärwicklung des Reststromtransformators bilden;
die Mehrfachwindungsinduktivität den Magnetkern umwickelt, um die Sekundärwicklung des Reststromtransformators (106) zu bilden;
die Mehrfachwindungsinduktivität und das Abtastwiderstandselement den RL-Multivibrator bilden;
die Abtastspannung aus den Enden des Abtastwiderstandselements erhalten wird.

3. DC-Reststromerkennungsvorrichtung nach Anspruch 2, wobei der Komparator (108) ein Verzögerungskomparator ist, der Komparator (108) einen ersten Operationsverstärker aufweist, ein gegenphasiges Eingangsende des ersten Operationsverstärkers über ein Strombegrenzungswiderstandselement mit dem Abtastwiderstandselement verbunden ist, um die Abtastspannung zu erhalten, ein phasengleiches Eingangsende des ersten Operationsverstärkers mit einer Schwellspannungserzeugungsschaltung verbunden ist, um die Schwellspannung zu erhalten, ein Ausgangsende des ersten Operationsverstärkers mit dem Strombegrenzungswiderstandselement und einem Filterkondensator verbunden ist, wobei das Strombegrenzungswiderstands-element und der Filterkondensator derart ausgeführt sind, dass sie eine Strombegrenzung, eine Interferenzunterdrückung und ein Filtern für das Ausgangssignal des ersten Operationsverstärkers durchführen.

4. DC-Reststromerkennungsvorrichtung nach Anspruch 3, wobei die Rechteckimpulsspannungs-Treiberschaltung (104) eine Halbbrückentreiberschaltung ist, die aus einem NPN-Transistor und einem PNP-Transistor gebildet ist, wobei die Basen der zwei Transistoren miteinander verbunden sind, wobei das zwischen positiv und negativ alternierende Rechtecksignal, das von dem Komparator ausgegeben wird, derart ausgeführt ist, dass es den NPN-Transistor und den PNP-Transistor alternierend führt, die Emitter der zwei Transistoren verbunden sind und eine Rechteckimpulsspannung zu der Sekundärwicklung des Reststromtransformators (106) ausgeben, der Kollektor des NPN-Transistors mit der positiven Energieversorgung verbunden ist und der Kollektor des PNP-Transistors mit der negativen Energieversorgung verbunden ist.

5. DC-Reststromerkennungsvorrichtung nach Anspruch 4, wobei der maximale Kollektorstrom des NPN-Transistors und des PNP-Transistors der Anzahl von Windungen der Mehrfachwindungsinduktivität, der Charakteristik des Magnetkerns und dem Widerstand des Abtastwiderstandselements zugeordnet ist.

6. DC-Reststromerkennungsvorrichtung nach Anspruch 4, wobei die selbstabgleichende Energieumwandlungsschaltung (102) einen zweiten Operationsverstärker aufweist, ein gleichphasiges Eingangsende des zweiten Operationsverstärkers mit einem Widerstandselement-Reihenspannungsteiler verbunden ist, zwei Enden des Widerstandselements-Reihenspannungsteilers jeweils mit dem positiven Ende und dem negativen Ende der unipolaren Energieversorgung (AA) verbunden sind, ein gegenphasiges Eingangsende des zweiten Operationsverstärkers über ein niederohmiges Widerstandselement mit Masse verbunden ist, ein Ausgangssignal des zweiten Operationsverstärkers mit dem gegenphasigen Eingangsende des zweiten Operationsverstärkers verbunden ist, um einen Spannungsfolger zu erstellen und zwei Energieversorgungen zu bilden, die symmetrisch sind: eine Energieversorgung ist von dem positiven Pol der unipolaren Energieversorgung (AA) und Masse gebildet, die andere Energieversorgung ist von Masse und dem negativen Pol der unipolaren Energieversorgung (AA) gebildet.

7. DC-Reststromerkennungsvorrichtung nach Anspruch 6, wobei der erste Operationsverstärker und der zweite Operationsverstärker vom gleichen Typ sind, der mit einer Anstiegsrate von ≥ 13 V/us, einer Gain-Bandbreite von ≥ 4 MHz und einem maximalen Stromausgang von ≥± 35 mA versehen ist.

8. DC-Reststromerkennungsvorrichtung nach Anspruch 6, wobei der RL-Multivibrator des Reststromtransformators eine RL-Multivibration auf der Basis der Charakteristik einer nichtlinearen Magnetisierungskurve von ferromagnetischem Material bildet;
die Sekundärwicklung des Reststromtransformators (106), die Rechteckimpulsspannungs-Treiberschaltung (104) und der Komparator (108) eine zyklische selbsterregende Oszillation bilden, eine Rechteckspannung an zwei Enden der Sekundärwicklung des Reststromtransformators (106) angelegt wird und zirkulierend die Richtung des Stroms ändert, der durch die Sekundärwicklung des Reststromtransformators (106) fließt, so dass der Magnetkern des Reststromtransformators (106) zwischen positiver Sättigung und negativer Sättigung alterniert.

9. DC-Reststromerkennungsvorrichtung nach Anspruch 8, wobei
wenn kein DC-Reststrom in der Primärwicklung des Reststromtransformators (106) vorhanden ist, der Positivsättigungserregungsstrom und der Negativsättigungserregungsstrom des Magnetkerns des Reststromtransformators (106) symmetrisch sind;
wenn ein DC-Reststrom in der Primärwicklung des Reststromtransformators (106) vorhanden ist, der Positivsättigungserregungsstrom und der Negativsättigungserregungsstrom des Magnetkerns des Reststromtransformators (106) asymmetrisch sind.

10. DC-Reststromerkennungsvorrichtung nach Anspruch 9, wobei
ein Mittelwert der von dem Komparator ausgegebenen Spannung die Polarität und Skalierung des DC-Reststroms in der Sekundärwicklung des Reststromtransformators (106) darstellt; der Mittelwert der Spannung dem Tastgrad des Rechtecksignals zugeordnet ist.

## Revendications

1. Appareil de détection de courant résiduel continu (DC), dans lequel l'appareil est commandé par une alimentation unipolaire (AA) et comprend un circuit d'autoéquilibrage de conversion de puissance (102), un circuit de commande de tension impulsionnelle à onde carrée (104), un transformateur de courant résiduel (106) et un comparateur (108) ;
une extrémité d'entrée du circuit d'auto-équilibrage de conversion de puissance (102) étant connectée à l'alimentation unipolaire (AA), le circuit d'auto-équilibrage de conversion de puissance (102) étant configuré pour convertir l'alimentation unipolaire (AA) en une alimentation bipolaire et pour fournir l'alimentation bipolaire, le circuit d'autoéquilibrage de conversion de puissance (102) étant configuré pour fournir l'alimentation au circuit de commande de tension impulsionnelle à onde carrée (104), au transformateur de courant résiduel (106) et au comparateur (108) ;
le transformateur de courant résiduel (106) étant formé avec un multivibrateur RL, le circuit de commande de tension impulsionnelle à onde carrée (104) étant configuré pour appliquer de manière circulaire des tensions positives ou négatives à un enroulement secondaire du transformateur de courant résiduel (106), le transformateur de courant résiduel (106) étant configuré pour délivrer une tension d'échantillonnage correspondante ;
le comparateur (108) étant configuré pour obtenir la tension d'échantillonnage délivrée par le transformateur de courant résiduel (106), pour comparer la tension d'échantillonnage avec une tension de seuil du comparateur (108) et pour générer un signal à onde carrée alternant entre positif et négatif, le signal à onde carrée étant renvoyé en tant que sortie du comparateur (108) au circuit de commande de tension impulsionnelle à onde carrée (104) en tant que signal de commande ;
la sortie du comparateur étant en outre utilisée comme sortie (BB) de l'appareil pour représenter une polarité et une échelle du courant résiduel DC.

2. Appareil de détection de courant résiduel DC selon la revendication 1, dans lequel le transformateur de courant résiduel (106) comprend un noyau magnétique, une inductance multi-tours et une résistance d'échantillonnage ;
le noyau magnétique est un matériau en alliage amorphe, une ligne de distribution pour la détection de courant résiduel DC passe par le noyau magnétique, la ligne de distribution et le noyau magnétique forment un enroulement primaire du transformateur de courant résiduel ;
l'inductance multi-tours s'enroule sur le noyau magnétique pour former l'enroulement secondaire du transformateur de courant résiduel (106) ;
l'inductance multi-tours et la résistance d'échantillonnage forment le multivibrateur RL ;
la tension d'échantillonnage est obtenue aux extrémités de la résistance d'échantillonnage.

3. Appareil de détection de courant résiduel DC selon la revendication 2, dans lequel le comparateur (108) est un comparateur à retardement, le comparateur (108) comprend un premier amplificateur opérationnel, une extrémité d'entrée en opposition de phase du premier amplificateur opérationnel est connectée à la résistance d'échantillonnage via une résistance de limitation de courant pour obtenir la tension d'échantillonnage, une extrémité d'entrée en phase du premier amplificateur opérationnel est connectée à un circuit de génération de tension de seuil pour obtenir la tension de seuil, une extrémité de sortie du premier amplificateur opérationnel est connectée à la résistance de limitation de courant et à un condensateur de filtrage, la résistance de limitation de courant et le condensateur de filtrage étant configurés pour limiter le courant, supprimer les interférences et filtrer la sortie du premier amplificateur opérationnel.

4. Appareil de détection de courant résiduel DC selon la revendication 3, dans lequel le circuit de commande de tension impulsionnelle à onde carrée (104) est un circuit de commande de tension en demi-pont composé d'un transistor NPN et d'un transistor PNP, les bases des deux transistors sont connectées l'une à l'autre, le signal d'onde carrée alternant entre positif et négatif, en sortie du comparateur, étant configuré pour conduire alternativement le transistor NPN et le transistor PNP, les émetteurs des deux transistors sont connectés et délivrent une tension impulsionnelle à onde carrée à l'enroulement secondaire du transformateur de courant résiduel (106), le collecteur du transistor NPN est connecté à l'alimentation positive, et le collecteur du transistor PNP est connecté à l'alimentation négative.

5. Appareil de détection de courant résiduel DC selon la revendication 4, dans lequel le courant de collecteur maximal du transistor NPN et du transistor PNP est associé au nombre de tours de l'inductance multi-tours, à la caractéristique du noyau magnétique et à la résistance de la résistance d'échantillonnage.

6. Appareil de détection de courant résiduel DC selon la revendication 4, dans lequel le circuit d'auto-équilibrage de conversion de puissance (102) comprend un second amplificateur opérationnel, une extrémité d'entrée en phase du second amplificateur opérationnel est connectée à un diviseur de tension à résistances en série, deux extrémités du diviseur de tension à résistances en série sont respectivement connectées à l'extrémité positive et à l'extrémité négative de l'alimentation unipolaire (AA), une extrémité d'entrée en opposition de phase du second amplificateur opérationnel est connectée à la masse par l'intermédiaire d'une résistance à faible résistance, une extrémité de sortie du second amplificateur opérationnel est connectée à l'extrémité d'entrée en opposition de phase du second amplificateur opérationnel pour construire un suiveur de tension et former deux alimentations qui sont symétriques : une alimentation est formée par le pôle positif de l'alimentation unipolaire (AA) et la masse, l'autre alimentation est formée par la masse et le pôle négatif de l'alimentation unipolaire (AA).

7. Appareil de détection de courant résiduel DC selon la revendication 6, dans lequel le premier amplificateur opérationnel et le second amplificateur opérationnel sont du même type, qui est doté d'une vitesse de balayage ≥ 13V / µs, d'une largeur de bande de gain ≥4 MHz et d'une sortie de courant maximale ≥ ± 3,5 mA.

8. Appareil de détection de courant résiduel DC selon la revendication 6, dans lequel le multivibrateur RL du transformateur de courant résiduel forme une multivibration RL basée sur la caractéristique de la courbe de magnétisation non linéaire du matériau ferromagnétique ;
l'enroulement secondaire du transformateur de courant résiduel (106), le circuit de commande de tension impulsionnelle à onde carrée (104) et le comparateur (108) forment une oscillation cyclique auto-excitée, une tension à onde carrée est appliquée sur deux extrémités de l'enroulement secondaire du transformateur de courant résiduel (106) et alterne circulairement le sens du courant circulant à travers l'enroulement secondaire du transformateur de courant résiduel (106), de sorte que le noyau magnétique du transformateur de courant résiduel (106) alterne entre une saturation positive et une saturation négative.

9. Appareil de détection de courant continu résiduel DC selon la revendication 8, dans lequel, lorsqu'aucun courant résiduel DC n'existe dans l'enroulement primaire du transformateur de courant résiduel (106), le courant d'excitation de saturation positive et le courant d'excitation de saturation négative du noyau magnétique du transformateur de courant résiduel (106) sont symétriques ;
lorsque le courant résiduel DC existe dans l'enroulement primaire du transformateur de courant résiduel (106), le courant d'excitation de saturation positive et le courant d'excitation de saturation négative du noyau magnétique du transformateur de courant résiduel (106) sont asymétriques.

10. Appareil de détection de courant résiduel DC selon la revendication 9, dans lequel une valeur moyenne de la tension délivrée par le comparateur représente la polarité et l'échelle du courant résiduel DC dans l'enroulement secondaire du transformateur de courant résiduel (106) ; la valeur moyenne de la tension est associée au rapport cyclique du signal d'onde carrée.
